# EUROPEAN PATENT SPECIFICATION

(11) **EP 2 728 741 B1**
(45) Date of publication and mention of the grant of the patent: **03.01.2018**
(21) Application number: 12360075.1
(22) Date of filing: 05.11.2012
(51) Int. Cl.: H03F 1/02, H03F 3/60

(54) **Amplifier**
Verstärker
Amplificateur

(43) Date of publication of application: 07.05.2014
(73) Proprietor: ALCATEL LUCENT, 92100 Boulogne-Billancourt (FR)
(72) Inventor: Wong, James, Swindon, Wiltshire SN5 7DJ (GB)
(74) Representative: Berthier, Karine

(56) References cited:
- WO-A2-2011/127868

## Description

### FIELD OF THE INVENTION

The present invention relates to a multi-frequency band amplifier, an amplification method, a method of a method of modulating power applied across an amplifier, a computer program product and an amplifier module.

### BACKGROUND

In most communications systems, it is required that power amplifiers used to amplify signals for transmission are able to operate with high efficiency and high linearity simultaneously. Improving and increasing the efficiency of power amplifiers, whilst supporting instantaneous signal bandwidths transmissions having a spacing of around 1GHz, may lead to issues. For example, due to wide signal bandwidths, complexity associated with Digital Pre-Distortion (DPD) techniques is likely to increase and ensuring efficient amplifier operation becomes more challenging as multiple bands are required to be transmitted through the same amplifier hardware.

Although amplifier arrangements provide for high efficiency operation, they may exhibit undesirable characteristics when used for bands spaced apart in the frequency domain.

WO2011/127868 describes a Doherty power amplifier comprising a broadband peak power amplifier whose input receives signals with at least two different narrowband frequencies, and at least two narrowband carrier power amplifiers connected in parallel with the peak power amplifier, whose inputs receive signals with a single narrowband frequency respectively and whose outputs are connected serially with a first impedance transformation network respectively. The output impedance of the combination of signals from the peak power amplifier and carrier power amplifiers is transformed into the load impedance through a second impedance transformation network so that the active load pull is made to the carrier power amplifiers through the peak power amplifier.

Accordingly, it is desired to provide an improved amplifier.

### SUMMARY

According to a first aspect, there is provided a multi-frequency band amplifier operable to receive a multi-frequency band input signal and to provide an amplified multi-frequency output signal at an amplifier output, said multi-frequency amplifier comprising: a plurality of main amplifier stages each arranged to receive a signal comprising one frequency band of the multi-frequency band input signal; a peak amplifier stage arranged to receive a signal comprising all frequency bands of the multi-frequency band input signal; each amplifier stage being arranged in parallel to receive said respective input signal and, when in an amplifying state, to provide a respective amplified signal at a respective amplifier stage output; and an amplifier output network coupled at a first side with a respective amplifier stage output and being coupled together in parallel at a second side with the amplifier output, the amplifier output network comprising a plurality of impedance transformers arranged to provide a frequency response matched to the multi-frequency band input signal, wherein said amplifier output network seen by said peak amplifier stage comprises at least one component selected such that the amplifier output network presents an effective phase length of approximately 180 degrees at each of said frequency bands of said multi-frequency band input signal, arranged such that an open circuit in an overall device plane presents an open circuit to a load.

The first aspect recognises that in most communications systems, it is required that power amplifiers used to amplify signals for transmission are able to operate with high efficiency and high linearity simultaneously. Many wireless telecommunications systems, such as Global System for Mobile Communications (GSM)/Enhanced Data Rates for GSM Evolution (EDGE), Code division multiple access (CDMA 2000) or Wideband Code Division Multiple Access (WCDMA) require that the power amplifier is able to deliver a wide range of output powers. Accordingly, power amplifiers provided in base stations are typically designed to provide the highest power output level with the maximum available efficiency.

A Doherty power amplifier is one parallel amplifier architecture in which a carrier amplifier is provided in parallel with a peaking amplifier. The input signal is split and provided to each of the two amplifiers. Both of the amplifiers then amplify the signal, which is then combined to create an output signal. When operating at the maximum power output, both amplifiers are utilised. However, when the total output power is typically less than 6dB from the maximum output power, the peaking amplifier is turned off. This arrangement provides higher efficiency compared to conventional class AB solutions since the carrier amplifier is biased in class AB, but the peaking amplifier is biased in class C and is turned off when the total output power is typically less than 6dB from the maximum output power level.

Aspects and embodiments described recognise that network operators increasingly wish to provide users with service using disparate regions or separated bands of frequency spectrum and that typically to do so they require an amplifier and output chain which operates independently for each of those frequency bands of interest. It is recognised that is may be beneficial to provide an amplifier that can be of use across more than one frequency band of interest, so allow a single amplifier to be provided to amplify a signal on a plurality of spaced frequency bands. Although known amplifier arrangements can provide for high efficiency operation, they may exhibit undesirable characteristics when used for bands spaced apart in the frequency domain. Even in an ideal case in which digital pre-distortion techniques can be used to linearise wide signal bandwidths, an amplifier active device component can itself cause non-ideal amplifier operation as a result of artifacts in a processed signal, such as video bandwidths, those artifacts causing particular issues in the case of wide signal bandwidths. Further issues may arise in order to maintain a low insertion loss associated with output isolators whilst allowing an amplifier to operate across a wide signal bandwidth.

The first aspect recognises that provision of a hybrid Doherty amplifier architecture can mitigate some of the issues with alternative amplifier arrangements. A hybrid Doherty amplifier arrangement in accordance with the first aspect comprises components arranged such that it substantially appears to each of the frequency bands in the multi frequency band input signal as a Doherty amplifier matched to each of the frequency bands.

Furthermore, the first aspect recognizes that by arranging the main amplifier stages or devices of the amplifier architecture such that they are each operable to amplify one each of the different frequency bands forming the multi-frequency input signal; and arranging the peak amplifier stage device such that it is operable to amplify a combined input signal, that is to say the combined signal across all frequency bands, video bandwidth issues associated with wideband amplifiers may be substantially eliminated.

In accordance with the first aspect, a two frequency band signal amplifier requires a total of three active devices to form the amplifier. In general, an n frequency band signal amplifier in accordance with the first aspect comprises n+1 active devices to form the amplifying stages. Such an arrangement thus offering possible improvements compared to alternative amplifier architectures regarding required printed circuit board size allocation.

According to one embodiment, each main amplifier stage may comprise an active device, those active devices may, according to some embodiments, comprise LDMOS (laterally diffused metal oxide semiconductor) transistor components, thus enabling low cost hybrid Doherty amplifier construction and manufacture.

According to one embodiment, the peak amplifier stage may comprise an active device, that active device may, according to some embodiments, comprise GaN (Gallium Nitride) transistor components. The requirement for only a single high-cost device to form an amplifier in accordance with the first aspect can enable low cost hybrid Doherty amplifier construction and manufacture.

According to one embodiment, the multi-frequency band input signal comprises a first band of frequency spectrum and at least one further band of frequency spectrum, the first and further band of frequency spectrum being selected such that they do not overlap. Accordingly, an amplifier arrangement in accordance with the first aspect may be of particular use for amplifying widely spaced region of radio spectrum using a single amplifier device. The principles of the amplifier architecture may enable ultra-wideband operation without a need to sacrifice efficient amplifier performance.

According to one embodiment, the amplifier output network seen by each of the plurality of main amplifier stages arranged to receive a signal comprising one frequency band of the multi-frequency band input signal comprises at least one component selected such that the amplifier output network presents an effective phase length of approximately 90 degrees at the one frequency band.

Accordingly, the frequency response of the amplifier output network which acts as a transforming and combining network is such that it allows multi-band amplifier operation.

According to one embodiment, the amplifier further comprises a signal conditioner operable to individually pre-process each input signal comprising one frequency band of the multi-frequency band input signal to be received by the plurality of main amplifier stages. Providing an amplifier arrangement having a high degree of linearization typically requires complex pre-processing of the input signal in order to compensate for the lack of linearity within the amplifier. In particular, it is typically necessary to apply complex pre-distortion functions to a signal to be amplified in order to compensate for and cancel the non-linearities introduced by the amplifier. Typically, this is achieved through the application of a fixed set of mathematical equations which define the pre-distortion to be applied. Such mathematical equations or functions are normally defined and fixed for particular operating conditions and rely on prediction mathematics to redefine these functions when the operating conditions change. It has been found that by pre-processing each of the frequency bands forming the multi-frequency band input signal, appropriate linearization can be achieved without a need to pre-process the combined signal passed to the peak amplifying stage. That is to say, amplifier arrangements in accordance with the first aspect may allow digital pre-distortion techniques to be applied to signals fed to the main amplifying devices only. As a result, the video-bandwidth limitations are such that it can be used with extremely wide instantaneous banded signals, for example, with instantaneous bandwidths separated by > 1GHz.

According to one embodiment, the amplifier further comprises a device output network comprising at least one bandpass filter and at least one hybrid coupler operable to separate the multi-frequency bands of the amplified multi-frequency output signal. The amplifier architecture outputs a single combined amplified signal which ultimately is for transmission to users in a network. In order to allow successful transmission to network users, the amplifier has a device output network arrangement comprising bandpass filters and hybrid couplers allow the frequencies which formed the input signal to be separated prior to being passed to banded isolators having a low insertion loss. Such an arrangement removes the need to use wideband isolators which typically have high insertion losses.

A second aspect provides a multi-frequency band input signal amplification method comprising: receiving a signal comprising one frequency band of the multi-frequency band input signal at each of a plurality of main amplifier stages; receiving a signal comprising all frequency bands of the multi-frequency band input signal at a peak amplifier stage; arranging each amplifier stage in parallel to receive the respective input signal and, when in an amplifying state, to provide a respective amplified signal at a respective amplifier stage output; and coupling an amplifier output network at a first side with a respective amplifier stage output, and coupling each amplifier stage in parallel at a second side with the amplifier output, the amplifier output network comprising a plurality of impedance transformers arranged to provide a frequency response matched to the multi-frequency band input signal, and wherein said amplifier output network seen by said peak amplifier stage comprises at least one component selected such that the amplifier output network presents an effective phase length of approximately 180 degrees at each of said frequency bands of said multi-frequency band input signal, arranged such that an open circuit in an overall device plane presents an open circuit to a load.

In one embodiment, the multi-frequency band input signal comprises a first band of frequency spectrum and at least one further band of frequency spectrum, the first and further band of frequency spectrum being selected such that they do not overlap.

In one embodiment, the method comprises selecting least one component such that the amplifier output network seen by the peak amplifier stage presents an effective phase length of approximately 180 degrees at each of said frequency bands of said multi-frequency band input signal, arranged such that an open circuit in an overall device plane presents an open circuit to a load.

In one embodiment, the method comprises selecting least one component such that the amplifier output network seen by each of the main amplifier stages arranged to receive a signal comprising one frequency band of said multi-frequency band input signal such that the amplifier output network presents an effective phase length of approximately 90 degrees at the one frequency band.

In one embodiment, the method comprises providing a signal conditioner operable to individually pre-process each input signal comprising one frequency band of the multi-frequency band input signal to be received by the plurality of main amplifier stages.

In one embodiment, the method comprises providing a device output network comprising at least one bandpass filter and at least one hybrid coupler operable to separate said multi-frequency bands of the amplified multi-frequency output signal.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figures 1a to 1e illustrate schematically various possible amplifier architectures;
Figure 2 illustrates schematically an amplifier architecture according to one embodiment;
Figure 3 illustrates schematically components of an amplifier according to one embodiment;
Figures 4a and 4b illustrate schematically principles of a mode of amplifier operation according to one arrangement;
Figure 5 illustrates schematically principles of a mode of amplifier operation according to one arrangement;
Figure 6 illustrates schematically how information collected via the principles illustrated by Figure 5 can be used to control operation of a peaking amplifier forming part of a parallel amplifier;
Figure 7a illustrates schematically the response of a hybrid coupler-bandpass filter network such as that illustrated by Figure 2;
Figure 7b illustrates schematically quad-band amplifier operation according to an embodiment; and
Figure 8 illustrates schematically Digital Pre-Distortion techniques for use with a hybrid amplifier.

### DESCRIPTION OF THE EMBODIMENTS

### Overview of Amplifier Architectures

There are many existing amplifier architectures, some of which are described with attached drawings:

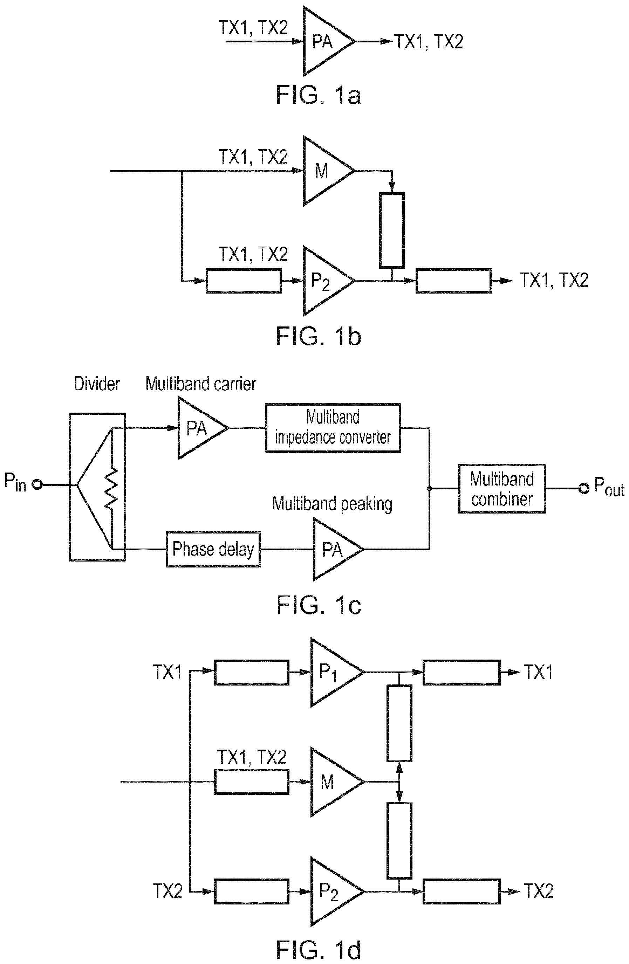

Figure 1a illustrates schematically a single-ended broadband class AB amplifier. Such amplifiers are typically available as off-the-shelf products and may offer broadband matching techniques. However, such amplifiers typically operate with a low efficiency and there can be issues in respect of addressing video bandwidth capabilities of the active device of such amplifiers, together with a need to address digital pre-distortion challenges. Single-ended broadband class AB amplifier also have issues with high insertion loss wideband power isolators.

Figure 1b illustrates schematically a typical wideband Doherty amplifier, which may offer an operating bandwidth of up to around 15-20% of operating band center frequency. However, GaN (Gallium Nitride) technology is typically required in order to support such wide signal bandwidths, which comes at a cost. The illustrated architecture has an impact on efficiency performance due to wider Peak-to-Average ratio signals; may suffer from video bandwidth limitations since issues associated with an active device have not been addressed, and an architecture as shown still fails to address digital pre-distortion challenges. Use of such an architecture in a telecommunications scenario may cause issues as a result of high insertion loss wideband power isolators. The architecture shown does not support signal bandwidths > 1GHz.

The amplifier architecture shown in Figure 1c offers multi-band operation but expensive GaN components are required in order to support such wide signal bandwidths. The architecture illustrated has a significant impact on efficiency performance due to wider peak-to-average ratio signals; video bandwidth limitations and issues still exist within the active device; does not address Digital Pre-Distortion challenges and there are issues with high insertion loss wideband power isolators.

The amplifier architecture shown in Figure 1d offers multi-band operation but expensive GaN components are required in order to support such wide signal bandwidths. The architecture illustrated has a significant impact on efficiency performance due to wider peak-to-average ratio signals; video bandwidth limitations and issues still exist within the active device; and does not address Digital Pre-Distortion challenges.

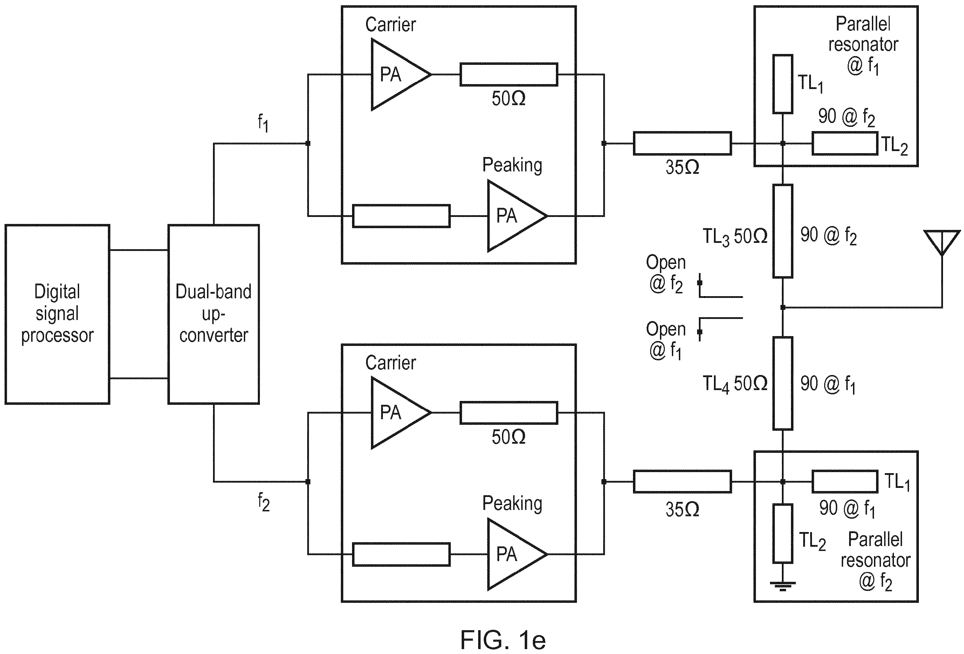

The amplifier architecture shown in Figure 1e offers multi-band operation by requires a large PCB real-estate and has a high manufacture cost due to the use of four active devices.

### Overview

Before discussing the embodiments in any more detail, first an overview will be provided. Aspects and embodiments address technical issues identified with amplifier architectures such as those described above.

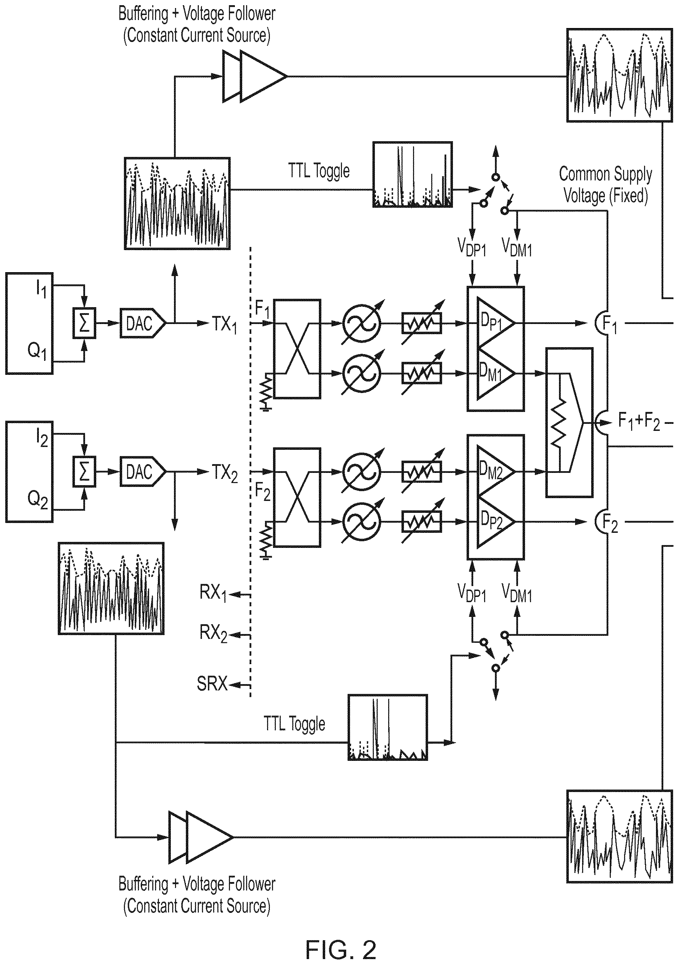

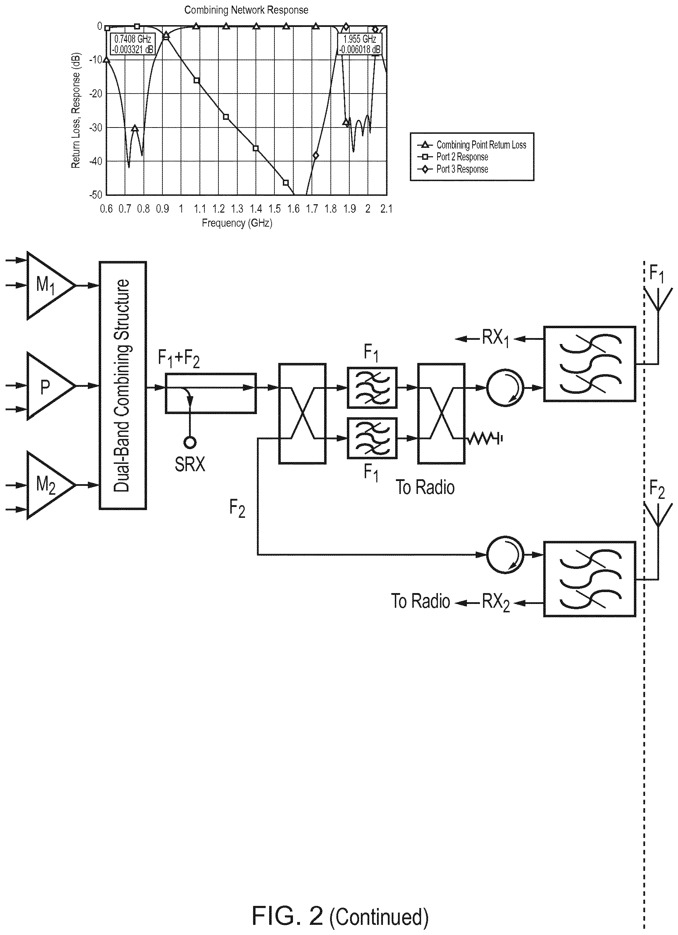

Figure 2 illustrates schematically an amplifier architecture according to one embodiment. The architecture shown in Figure 2 is suited to the amplification of two transmitting signals F1, F2. The example amplifier shown in Figure 2 comprises two active devices which operate as main amplifiers. Those active devices may, according to some embodiments, comprise LDMOS components enabling low cost amplifier manufacture. The example amplifier shown further comprises a single active device peaking amplifier. The peaking amplifier comprises an appropriate GaN component.

A typical Doherty amplifier comprises a main amplifying stage and one or more auxiliary amplifying stages. The number of amplifying stages that are in the amplifying state varies in dependence on the power output required from the Doherty amplifier. When less power is required to be output by the Doherty amplifier, then one or more of the auxiliary amplifying stages will be switched off.

Each amplifying stage amplifies the input signal in parallel and the amplified output of each of the amplifying stages is combined to provide an amplified output signal. Accordingly, typically an input network is provided which feeds the signal to be amplified in parallel to each of the amplifying stages. Also, an output network is typically provided which receives each amplified output signal and combines these to provide an amplified output to a load.

Typically the input network provides necessary phase shifts to the input signals being fed to each of the amplifier stages. Likewise, the output network provides the necessary phase shift prior to combining the output signals provided by each of the amplifying stages. The characteristics of the input and output networks are usually carefully selected to provide both the required phase shifts and provide impedance matching in order to maximise power transfer into a load.

The operation of the amplifier illustrated in Figure 2 is similar to that of a classic Doherty. For a two frequency band signal amplifier as shown in Figure 2, a total of three active devices is used to form the amplifier, thereby offering possible improvements compared to alternative amplifier architectures regarding required printed circuit board size allocation.

The main devices of the amplifier architecture shown in Figure 2 are operable to each amplify one each of the input signals F1 & F2 having different frequency bands. The peaking device is operable to amplify a combined input signal, that is to say the combined signal of F1 + F2. It has been found that such an arrangement substantially eliminates the video bandwidth issues associated with wideband amplifiers. The illustrated architecture is supported by data having a different digital pre-distortion architecture that allows for use of the non-linearities contributed by each main device and can be sufficient to linearise overall operation of the amplifier.

The principles of the amplifier architecture illustrated in Figure 2 may enable ultra-wideband operation without a need to sacrifice efficient amplifier performance.

The amplifier architecture shown in Figure 2 outputs a single combined amplified signal which ultimately is for transmission to users in a network. In order to allow successful transmission to network users, the amplifier has an output network arrangement comprising bandpass filters and hybrid couplers allow the frequencies which formed the input signal (F1 and F2) to be separated prior to being passed to banded isolators having a low insertion loss. Such an arrangement removes the need to use wideband isolators which typically have high insertion losses.

Table 1 provides a comparison summary of amplifier architectures, illustrating the benefits of adopting an architecture similar to Figure 2 to enable ultra-wide and multi-band operation.

**Table 1**

| **Architecture Type** | **Efficiency** | **Video Bandwidth Issues** | **DPD Implementation Challenges** | **PCB Real Estate** | **Isolator Issues** | **BOM Cost** |
|---|---|---|---|---|---|---|
| Figure 1a | Low | Yes | High | Low | Yes | Low |
| Figure 1b | Medium | Yes | High | Medium | Yes | Med-High |
| Figure 1c | Medium | Yes | High | Medium | Yes | Med-High |
| Figure 1d | Medium | Yes | High | Medium | No | Med-High |
| Figure 1e | High | No | Low | High | Yes | Med-High |
| Figure 2 | High | No | Low | Low-Medium | No | Med-High |

### Amplifier Architecture

In order to ensure that the amplifier architecture receives a combination of signals F1 and F2 which can be successfully amplified, the phase and amplitude balance of those signals are adjusted by voltage controlled phase shifters and attenuators prior to injecting them into the respective main (and peak) driver stages.

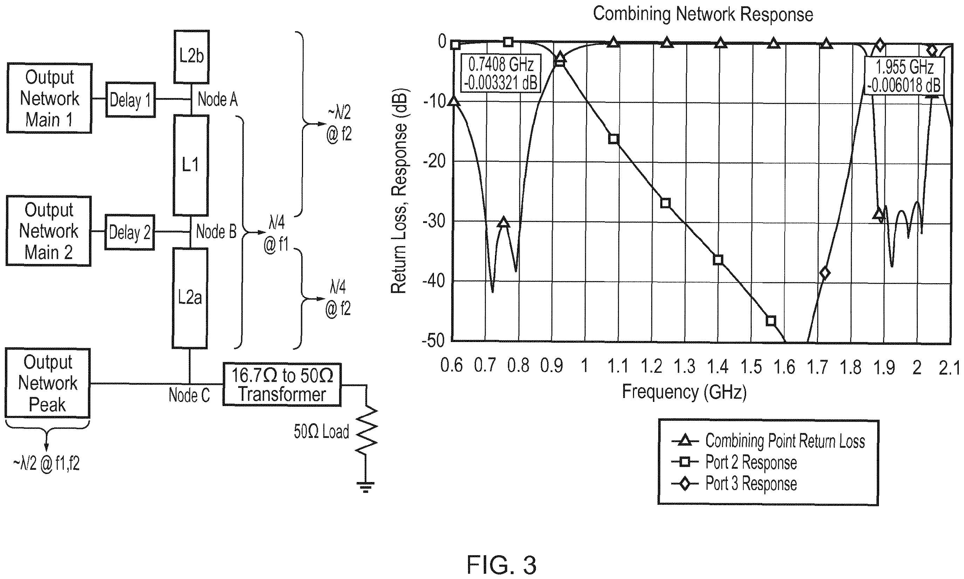

Figure 3 illustrates schematically components of an amplifier according to one embodiment. In particular, Figure 3 shows a simple block diagram of a dual band combining network operating at 700MHz and 1900MHz. In the example architecture shown, the output of Main 1 is reserved for lower frequency band amplification and the output of Main 2 is reserved for the higher frequency band amplification. The output network of the peaking device is arranged to have an effective phase length of approximately 180degrees (λ/2) such that an open circuit at the device plane will present an open circuit at Node C.

Taking amplifier Main 2 in operation: L2a is arranged to provide an electrical length of approximately λ/4 at frequency F2. The sum of L2b and L1 is chosen such that an open circuit is presented at Node B. Delay 1 is provided at the output network of Main 1 such that it presents an open circuit at Node B, as a result, the signal at frequency F2 does not 'see' the network of Main 1. For Main 1, delay 2 is inserted at the output network of Main 2 such that it presents an open circuit at Node B, so that the signal at frequency F1 does not 'see' the network of Main 2. The effective electrical lengths of L1 and L2a are chosen to be approximately λ/4 at frequency F1.

The resulting signals as passed through Main 1 and Main 2 are combined at Node C together with the output from the peaking amplifier. A frequency response of such a transforming and combining network is shown in the graph forming the right hand side of Figure 3. The principles described in relation to Figures 2 and 3 can be extended to enable Tri-Band and Quad-Band operation.

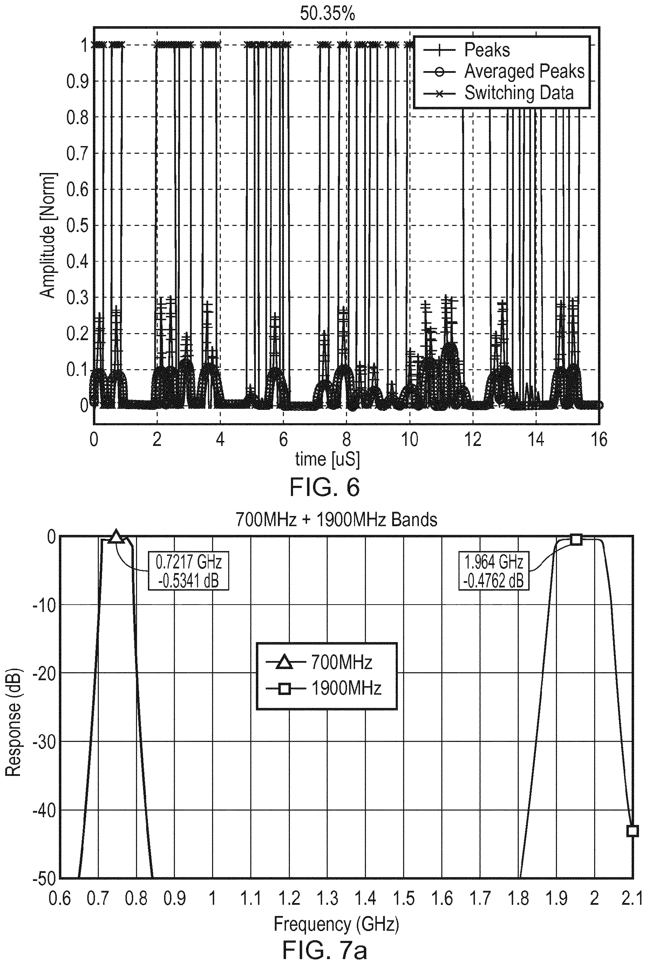

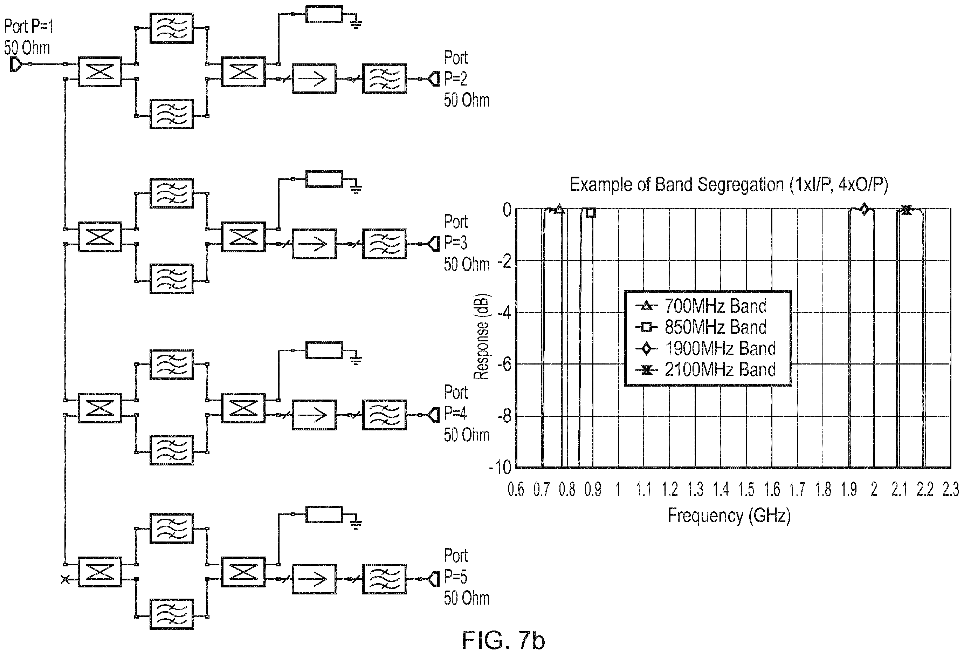

Figure 7a illustrates schematically the response of a hybrid coupler-bandpass filter network such as that illustrated by Figure 2 and Figure 7b illustrates schematically quad-band amplifier operation according to an alternative embodiment.

An amplifier arrangement in accordance with the described principles can allow multiple signals on a signal transmission path to be segregated into their respective transmitting antenna ports. In a typical single frequency transmission line-up (post amplifier output, prior to a directional coupler), total insertion loss post amplifier output is given by the sum of insertion losses relating to each of a directional coupler, isolator and diplexer. Typically such insertion loss has a value in the region of 1.1db, with the diplexer contributing significantly to the insertion loss, by having an insertion loss itself in the region of about 0.7dB. According to amplifier aspects and embodiments described herein, the rejection of the diplexer is shared with a bandpass filter. This can result in the use of a smaller sized diplexer with improved insertion loss since there is an ease of requirements in relation to the rejection post isolator.

Figure 7a shows that the insertion loss of an arrangement such as that shown in Figure 2 using a pre-smaller diplexer is <0.6dB, implying that such an arrangement can result in a total insertion loss less than or equal to that of the conventional approach.

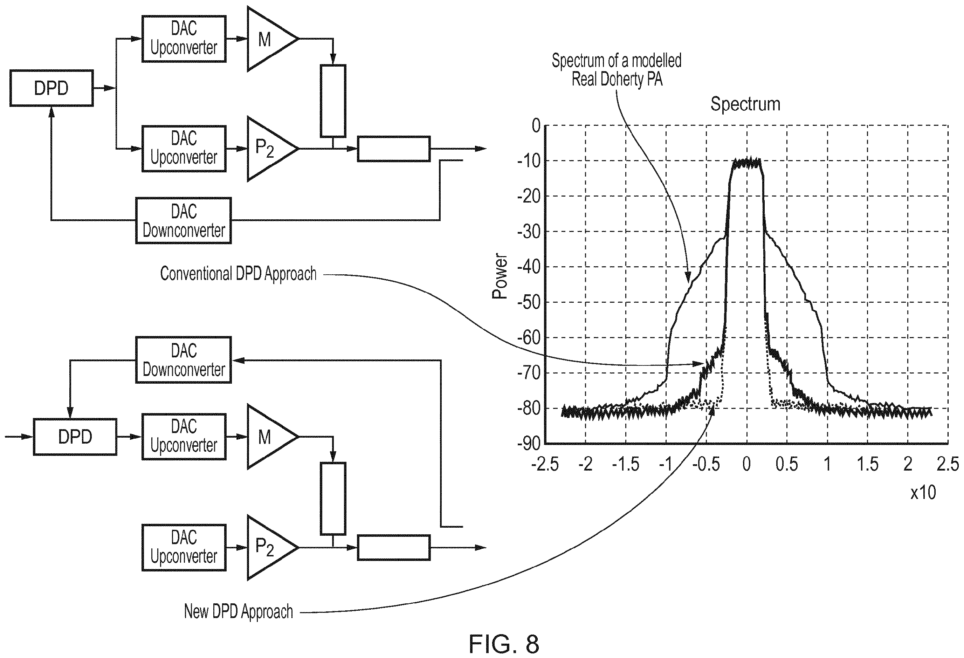

Figure 8 illustrates schematically Digital Pre-Distortion techniques for use with a hybrid amplifier such as that shown in Figure 2. Figure 8 illustrates that it has been found that the use of hybrid amplifiers such as the example shown in Figure 2 can allow digital pre-distortion techniques to be applied to signals fed to the main amplifying devices only. As a result, the video-bandwidth limitations of the arrangement shown are such that it can be used with extremely wide instantaneous banded signals, for example, with instantaneous bandwidths separated by > 1GHz.

### Envelope Tracking Techniques

Arrangements may further enhance the efficiency performance of an amplifier pallet such as that shown in Figure 2, but may also be used to improve efficient operation of other amplifier pallets. According to the further aspect, signals F1 & F2 can be processed to determine a slow drain voltage waveform, in a concept not too dissimilar to envelope tracking. Appropriate signal processing can, in accordance with the further aspects and embodiments, be used to generate a variable drain voltage to the main devices with a modulation rate that is only a fraction of that required for "true" envelope-tracking, yet still provide an improvement in amplifier efficiency. The lower modulation rate of described aspects can allow for implementation of envelope-tracking type techniques across wider signal bandwidths than true envelope-tracking, thus, for example, signal bandwidths >20MHz < 80MHz may be supported.

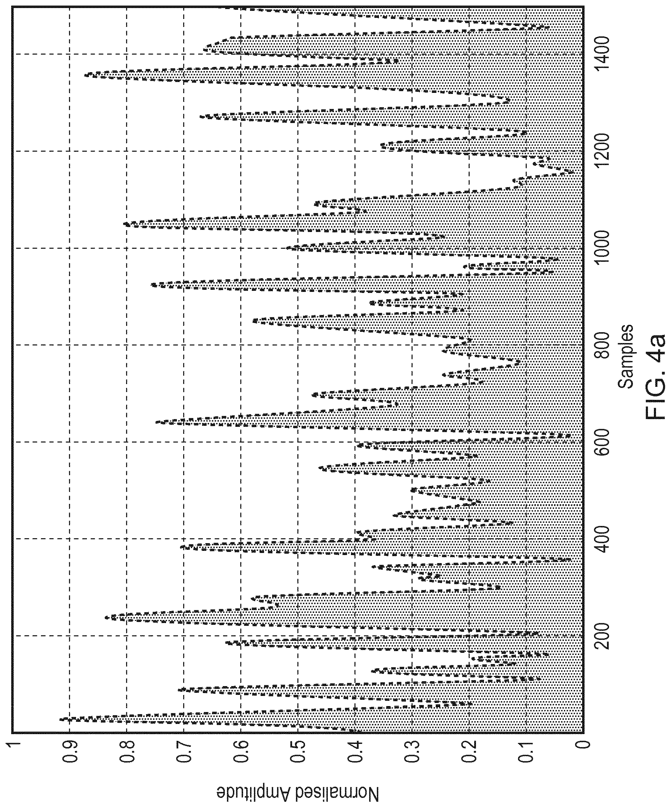

Figure 4a illustrates a typical time domain envelope of a 5MHz LTE signal, shown by the shaded area under the curve. The dotted trace shows an ideal "true"envelope tracking modulator, tracking the envelope of the signal and according to which an appropriate drain supply voltage is applied at each point in time. The light coloured area represents power saved over time by applying true envelope tracking in comparison to a fixed drain supply voltage.

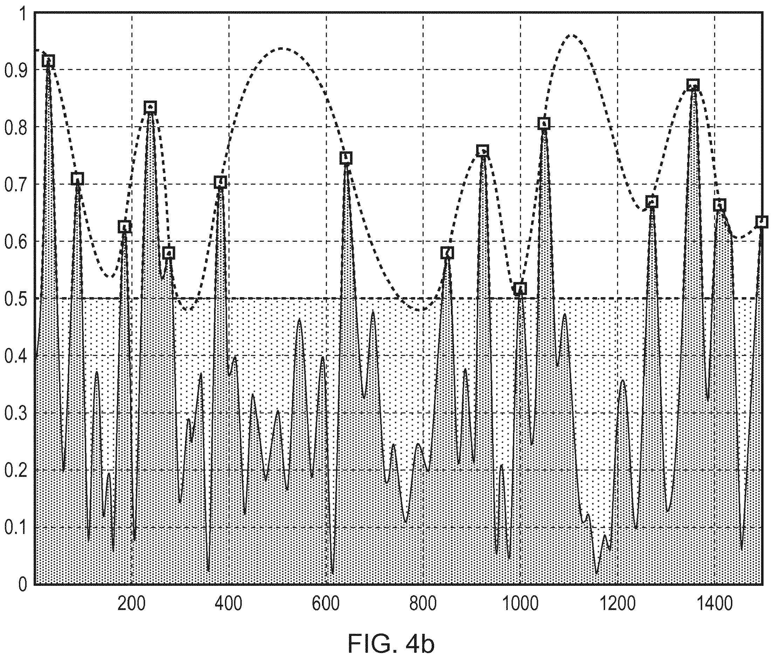

Figure 4b shows an alternative approach to envelope tracking in accordance with one arrangement. According to such an approach, an average drain supply voltage level is selected or preselected such that a slower modulation rate accounts for "peaks" above the selected average level. The slower modulation rate is illustrated by the dotted curve, the peaks are marked, and the dotted curve passes through the peak markers. By adjusting the average threshold level (illustrated by the horizontal dotted trace in Figure 4b) the number of peaks, and therefore the rate of modulation, can be readjusted. Although the power consumption savings may not be comparable to ideal envelope tracking such methods can still offer power consumption savings compared to using a constant fixed voltage supply. Furthermore, such an approach requires a much slower modulation rate compared with envelope tracking and is therefore less restricted by device hardware limitations than true envelope tracking. True envelope tracking can require high cut-off frequency for switching, which also acts as a factor limiting the signal bandwidth. Arrangements described can support wider signal bandwidths than current envelope tracking techniques which can typically only support up to 20MHz of signal bandwidth. The new approach having a reduced modulation rate can support in the region of up to 80MHz of signal bandwidth. Slow modulation envelope tracking can therefore provide an attractive feature especially at low transmission power levels.

### Peak Amplifier Power Savings

A yet further arrangement may provide signal processing which can also determine the conducting state of a peaking amplifier used in parallel amplifiers, such as a traditional Doherty amplifier, or amplifier arrangements such as that shown in Figure 2, the signal processing allowing operation of the amplifier such that drivers to peaking devices can be toggled on or off in accordance with the determined conducting state of the peaking amplifier.

To further improve amplifier pallet efficiency, the driver chains to the peaking devices may be provided with a switch to toggle between on and off-states. During the on-state, the driver is biased in Class AB. This ensures that the overall line-up gain is not impacted unlike the case of biasing the driver stages in Class C.

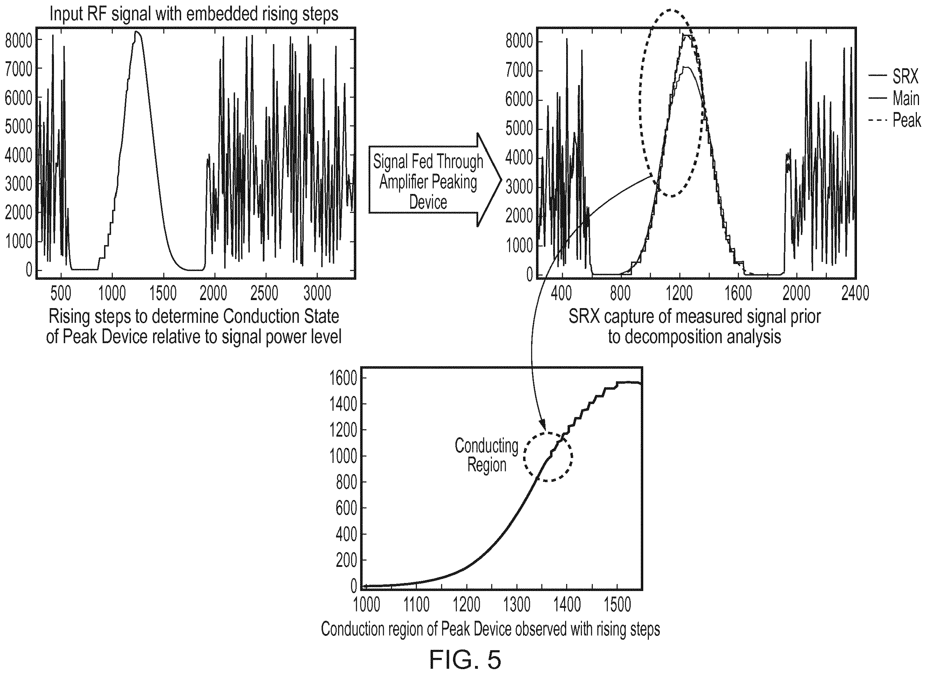

Figure 5 illustrates schematically principles of a mode of amplifier operation according to one arrangement. The signal to be transmitted as the input to the amplifier is first digitally processed. Figure 5 illustrates that an injected signal to a peaking device is that of a typical LTE signal, but with an embedded pulse with rising steps on the rising edge. The purpose of the embedded pulse signal is to determine the conduction region of the peaking amplifier. During the low levels, the peaking amplifier is not conducting and can clearly observed by the smooth rising curve of the output of the peaking amplifier shown in Figure 5. At higher larger amplitudes, rising steps begin to appear, indicating the conduction region of the peaking amplifier. This information can be used to generate a trigger level for a switching circuit, operable to toggle the gate voltage to the driver stage between on and off in correspondence with the conduction state of the peaking amplifier. That toggle process is illustrated schematically in Figure 6.

Aspects and embodiments described enable ultra-wide multi-band operation of a radio transmitting system, without incurring penalties such as cost, weight, size and performance. Amplifier architectures such as those described can valuable within the telecommunications sector since they offer a means to addresses network operator demands for reduced assets whilst being capable of supporting higher capacity without incurring additional capital and operating cost penalties.

Aspects and embodiments described may allow for requirements such as: multiple-band, ultra-widely spaced instantaneous band support, the amplifier architecture suggested has small form factor and can provide high efficiency performance with minimum cost penalties. Furthermore, suggested and described techniques have no impact on legacy digital pre-distortion algorithms or hardware architectures.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A multi-frequency band amplifier operable to receive a multi-frequency band input signal and to provide an amplified multi-frequency output signal at an amplifier output, said multi-frequency amplifier comprising:
a plurality of main amplifier stages each arranged to receive a signal comprising one frequency band of said multi-frequency band input signal;
a peak amplifier stage arranged to receive a signal comprising all frequency bands of said multi-frequency band input signal;
each amplifier stage being arranged in parallel to receive said respective input signal and, when in an amplifying state, to provide a respective amplified signal at a respective amplifier stage output; and
an amplifier output network coupled at a first side with a respective amplifier stage output and being coupled together in parallel at a second side with said amplifier output, said amplifier output network comprising a plurality of impedance transformers arranged to provide a frequency response matched to said multi-frequency band input signal, and wherein said amplifier output network seen by said peak amplifier stage comprises at least one component selected such that the amplifier output network presents an effective phase length of approximately 180 degrees at each of said frequency bands of said multi-frequency band input signal, arranged such that an open circuit in an overall device plane presents an open circuit to a load.

2. A multi-frequency band amplifier according to claim 1, wherein said multi-frequency band input signal comprises a first band of frequency spectrum and at least one further band of frequency spectrum, said first and further band of frequency spectrum being selected such that they do not overlap.

3. A multi-frequency band amplifier according to any preceding claim, wherein said amplifier output network seen by each of said plurality of main amplifier stages arranged to receive a signal comprising one frequency band of said multi-frequency band input signal comprises at least one component selected such that the amplifier output network presents an effective phase length of approximately 90 degrees at said one frequency band.

4. A multi-frequency band amplifier according to any preceding claim, wherein said amplifier further comprises a signal conditioner operable to individually pre-process each input signal comprising one frequency band of said multi-frequency band input signal to be received by said plurality of main amplifier stages.

5. A multi-frequency band amplifier according to any preceding claim, wherein said amplifier further comprises a device output network comprising at least one bandpass filter and at least one hybrid coupler operable to separate said multi-frequency bands of said amplified multi-frequency output signal.

6. A multi-frequency band input signal amplification method comprising:
receiving a signal comprising one frequency band of said multi-frequency band input signal at each of a plurality of main amplifier stages;
receiving a signal comprising all frequency bands of said multi-frequency band input signal at a peak amplifier stage;
arranging each amplifier stage in parallel to receive said respective input signal and, when in an amplifying state, to provide a respective amplified signal at a respective amplifier stage output; and
coupling an amplifier output network at a first side with a respective amplifier stage output, and coupling each amplifier stage in parallel at a second side with said amplifier output, said amplifier output network comprising a plurality of impedance transformers arranged to provide a frequency response matched to said multi-frequency band input signal, and wherein said amplifier output network seen by said peak amplifier stage comprises at least one component selected such that the amplifier output network presents an effective phase length of approximately 180 degrees at each of said frequency bands of said multi-frequency band input signal, arranged such that an open circuit in an overall device plane presents an open circuit to a load.

## Patentansprüche

1. Multifrequenzband-Verstärker, betreibbar zum Empfangen eines Multifrequenzband-Eingangssignals und zum Bereitstellen eines verstärkten Multifrequenzband-Ausgangssignals an einem Verstärkerausgang, wobei besagter Multifrequenz-Verstärker umfasst:
eine Vielzahl von Hauptverstärkerstufen, wobei jede angeordnet ist zum Empfangen eines Signals, das ein Frequenzband besagten Multifrequenzband-Eingangssignals umfasst;
eine Spitzenverstärkerstufe, die angeordnet ist zum Empfangen eines Signals, das alle Frequenzbänder besagten Multifrequenzband-Eingangssignals umfasst;
wobei jede Verstärkerstufe parallelgeschaltet ist zum Empfangen des besagten entsprechenden Eingangssignals und, im Verstärkungszustand, zum Bereitstellen eines entsprechenden verstärkten Signals an einem entsprechenden Verstärkerstufenausgang; und
ein Verstärkerausgangsnetzwerk, das an einer ersten Seite mit einem entsprechenden Verstärkerstufenausgang gekoppelt ist und an einer zweiten Seite parallel gekoppelt ist mit besagtem Verstärkerausgang, wobei besagtes Verstärkerausgangsnetzwerk umfasst eine Vielzahl von Impedanzwandlern, die angeordnet sind zum Bereitstellen einer Frequenzantwort, die zu besagtem Multifrequenzband-Eingangssignal passt, und wobei besagtes Verstärkerausgangsnetzwerk, gesehen von besagter Spitzenverstärkerstufe, umfasst mindestens eine Komponente, die so ausgewählt ist, dass das Verstärkerausgangsnetzwerk eine effektive Phasenlänge von ungefähr 180 Grad an jedem besagter Frequenzbänder von besagtem Multifrequenzband-Eingangssignal darstellt, dergestalt angeordnet, dass ein offener Schaltkreis in einer Gesamtvorrichtungsebene einen für eine Last offenen Schaltkreis darstellt.

2. Multifrequenzband-Verstärker nach Anspruch 1, wobei besagtes Multifrequenzband-Eingangssignal umfasst ein erstes Band eines Frequenzspektrums und mindestens ein weiteres Band eines Frequenzspektrums, wobei besagtes erstes und weiteres Band eines Frequenzspektrums so ausgewählt werden, sodass sie nicht überlappen.

3. Multifrequenzband-Verstärker nach einem beliebigen der vorhergehenden Ansprüche, wobei besagtes Verstärkerausgangsnetzwerk, gesehen von jeder besagter Vielzahl von Hauptverstärkerstufen, die angeordnet sind zum Empfangen eines Signals, das ein Frequenzband besagten Multifrequenzband-Eingangssignals umfasst, mindestens eine Komponente umfasst, die so ausgewählt ist, dass das Verstärkerausgangsnetzwerk eine effektive Phasenlänge oder ungefähr 90 Grad an besagtem einen Frequenzband darstellt.

4. Multifrequenzband-Verstärker nach einem beliebigen der vorhergehenden Ansprüche, wobei besagter Verstärker weiterhin umfasst einen Signalkonditionierer, der betreibbar ist zum individuellen Vorbearbeiten eines jeden Eingangssignals, umfassend ein Frequenzband von besagtem Multifrequenzband-Eingangssignal, das von besagter Vielzahl von Hauptverstärkerstufen empfangen werden soll.

5. Multifrequenzband-Verstärker nach einem beliebigen der vorhergehenden Ansprüche, wobei besagter Verstärker weiterhin umfasst ein Vorrichtungsausgangsnetzwerk, das mindestens einen Bandpassfilter und mindestens einen Hybridkoppler umfasst, der betreibbar ist zum Trennen besagter Multifrequenzbänder von besagtem verstärkten Multifrequenz-Ausgangssignal.

6. Multifrequenzband-Eingangssignal-Verstärkungsverfahren, umfassend:
Empfangen eines Signals, das ein Frequenzband von besagtem Multifrequenzband-Eingangssignal an jeder der Vielzahl von Hauptverstärkerstufen umfasst;
Empfangen eines Signals, das alle Frequenzbänder von besagtem Multifrequenzband-Eingangssignal an einer Spitzenverstärkerstufe umfasst,
paralleles Anordnen einer jeden Verstärkerstufe zum Empfangen besagten entsprechenden Eingangssignals und, im Verstärkungszustand, zum Bereitstellen eines entsprechenden verstärkten Signals an einem entsprechenden Verstärkerstufenausgang; und
Koppeln eines Verstärkerausgangsnetzwerks an einer ersten Seite mit einem entsprechenden Verstärkerstufenausgang, und paralleles Koppeln einer jeden Verstärkerstufe an einer zweiten Seite mit besagtem Verstärkerausgang, wobei besagtes Verstärkerausgangsnetzwerk eine Vielzahl von Impedanzwandlern umfasst, die angeordnet sind zum Bereitstellen einer Frequenzantwort, die zu besagtem Multifrequenzband-Eingangssignal passt, und wobei besagtes Verstärkerausgangsnetzwerk, gesehen von besagter Spitzenverstärkerstufe, mindestens eine Komponente umfasst, die so ausgewählt ist, dass das Verstärkerausgangsnetzwerk eine effektive Phasenlänge von ungefähr 180 Grad an jedem besagter Frequenzbänder von besagtem Multifrequenzband-Eingangssignal darstellt, dergestalt angeordnet, dass ein offener Schaltkreis in einer Gesamtvorrichtungsebene einen für eine Last offenen Schaltkreis darstellt.

## Revendications

1. Amplificateur de bande à fréquences multiples permettant de recevoir un signal d'entrée de bande à fréquences multiples et de fournir un signal de sortie à fréquences multiples amplifié à une sortie d'amplificateur, ledit amplificateur à fréquences multiples comprenant :
une pluralité d'étages d'amplificateur principal, chacun étant conçu pour recevoir un signal comprenant une bande de fréquences dudit signal d'entrée de bande à fréquences multiples ;
un étage d'amplificateur de crête conçu pour recevoir un signal comprenant toutes les bandes de fréquences dudit signal d'entrée de bande à fréquences multiples ;
chaque étage d'amplificateur étant disposé en parallèle pour recevoir ledit signal d'entrée respectif et, lorsqu'il est en état d'amplification, pour fournir un signal amplifié respectif à une sortie d'étage d'amplificateur respective ; et
un réseau de sortie d'amplificateur couplé au niveau d'un premier côté à une sortie d'étage d'amplificateur respective et étant couplé ensemble en parallèle au niveau d'un deuxième côté à ladite sortie d'amplificateur, ledit réseau de sortie d'amplificateur comprenant une pluralité de transformateurs d'impédance conçus pour fournir une réponse en fréquence correspondant audit signal d'entrée de bande à fréquences multiples, et dans lequel ledit réseau de sortie d'amplificateur vu par ledit étage d'amplificateur de crête comprend au moins un composant sélectionné de sorte que le réseau de sortie d'amplificateur présente une longueur de phase effective d'environ 180 degrés à chacune desdites bandes de fréquences dudit signal d'entrée de bande à fréquences multiples, conçu de sorte qu'un circuit ouvert dans un plan de dispositif global présente un circuit ouvert à une charge.

2. Amplificateur de bande à fréquences multiples selon la revendication 1, dans lequel ledit signal d'entrée de bande à fréquences multiples comprend une première bande de spectre de fréquences et au moins une autre bande de spectre de fréquences, ladite première et ladite autre bande de spectre de fréquences étant choisies de sorte qu'elles ne se chevauchent pas.

3. Amplificateur de bande à fréquences multiples selon l'une quelconque des revendications précédentes, dans lequel ledit réseau de sortie d'amplificateur vu par chaque étage parmi ladite pluralité d'étages d'amplificateur principal conçu pour recevoir un signal comprenant une bande de fréquences dudit signal d'entrée de bande à fréquences multiples comprend au moins un composant choisi de sorte que le réseau de sortie d'amplificateur présente une longueur de phase effective d'environ 90 degrés à ladite bande de fréquences.

4. Amplificateur de bande à fréquences multiples selon l'une quelconque des revendications précédentes, dans lequel ledit amplificateur comprend en outre un conditionneur de signal permettant de pré-traiter individuellement chaque signal d'entrée comprenant une bande de fréquences dudit signal d'entrée de bande à fréquences multiples devant être reçu par ladite pluralité d'étages d'amplificateur principal.

5. Amplificateur de bande à fréquences multiples selon l'une quelconque des revendications précédentes, dans lequel ledit amplificateur comprend en outre un réseau de sortie de dispositif comprenant au moins un filtre passe-bande et au moins un coupleur hybride permettant de séparer lesdites bandes à fréquences multiples dudit signal de sortie à fréquences multiples amplifié.

6. Procédé d'amplification de signal d'entrée de bande à fréquences multiples comprenant les étapes suivantes :
recevoir un signal comprenant une bande de fréquences dudit signal d'entrée de bande à fréquences multiples à chaque étage parmi une pluralité d'étages d'amplificateur principal ;
recevoir un signal comprenant toutes les bandes de fréquences dudit signal d'entrée de bande à fréquences multiples à un étage d'amplificateur de crête ;
disposer chaque étage d'amplificateur en parallèle pour recevoir ledit signal d'entrée respectif et, lorsqu'il est en état d'amplification, pour fournir un signal amplifié respectif à une sortie d'étage d'amplificateur respective ; et
coupler un réseau de sortie d'amplificateur au niveau d'un premier côté à une sortie d'étage d'amplificateur respective, et coupler chaque étage d'amplificateur en parallèle au niveau d'un deuxième côté à ladite sortie d'amplificateur, ledit réseau de sortie d'amplificateur comprenant une pluralité de transformateurs d'impédance conçus pour fournir une réponse en fréquence correspondant audit signal d'entrée de bande à fréquences multiples, et dans lequel ledit réseau de sortie d'amplificateur vu par ledit étage d'amplificateur de crête comprend au moins un composant sélectionné de sorte que le réseau de sortie d'amplificateur présente une longueur de phase effective d'environ 180 degrés à chacune desdites bandes de fréquences dudit signal d'entrée de bande à fréquences multiples, conçu de sorte qu'un circuit ouvert dans un plan de dispositif global présente un circuit ouvert à une charge.
